Europäisches Patentamt

European Patent Office

Office européen des brevets

(19)

(11) EP 0 493 833 B1

(12) FASCICULE DE BREVET EUROPEEN

(45) Date de publication et mention
de la délivrance du brevet:
03.04.1996 Bulletin 1996/14

(51) Int Cl.⁶: H01L 39/24

(21) Numéro de dépôt: 91122379.0

(22) Date de dépôt: 30.12.1991

(54) **Procédé de fabrication d'un élément du genre fil ou ruban en matériau à base d'oxyde supraconducteur à haute température critique et élément ainsi obtenu**

Verfahren zur Herstellung eines Draht- oder Bandelementes aus Material auf der Basis supraleitender Oxyde

Method of producing a wire or tape element of material based on superconducting oxide

(84) Etats contractants désignés:
DE FR IT

(30) Priorité: 04.01.1991 FR 9100070

(43) Date de publication de la demande:
08.07.1992 Bulletin 1992/28

(73) Titulaire: ALCATEL ALSTHOM COMPAGNIE GENERALE D'ELECTRICITE
F-75382 Paris Cédex 08 (FR)

(72) Inventeur: Belouet, Christian
F-92330 Sceaux (FR)

(74) Mandataire: Weinmiller, Jürgen
Lennéstrasse 9
Postfach 24
D-82336 Feldafing (DE)

(56) Documents cités:
EP-A- 0 300 353        WO-A-88/09312

- PATENT ABSTRACTS OF JAPAN vol. 14, no. 142 (E-904) 16 Mars 1990 & JP-A-2 007 309
- JAPANESE JOURNAL OF APPLIED PHYSICS vol. 28, no. 4, Avril 1989, TOKYO, JP, pages L618-L620; Y. Morii et al.: "Neutron diffraction study on the crystal orientation of Y-Ba-Cu-O superconducting material aligned in the magnetic field."

## Description

La présente invention concerne un procédé de fabrication d'un élément du genre fil ou ruban en matériau à base d'oxyde supraconducteur à haute température critique.

Les oxydes supraconducteurs sont des composés aux propriétés très anisotropes. Ainsi la densité de courant critique Jc dans les plans perpendiculaires à la direction $\vec{c}$ de la maille cristalline, est supérieure de deux ordres de grandeur à celle mesurée dans la direction $\vec{c}$. Cet effet est encore amplifié en présence d'un champ magnétique. L'utilisation de ces matériaux en électrotechnique requiert des valeurs de Jc à 77 K supérieures à $10^4$ A/cm$^2$, si possible sous des champs élevés, par exemple de quelques Teslas selon les applications.

Ils sont actuellement préparés par des procédés utilisés dans la technique des céramiques (pressage et frittage), ou par solidification dirigée et cristallisation de matrices vitreuses. On sait en effet que des compositions d'oxydes supraconducteurs à haute température critique se prêtent à la vitrification.
Le passage par la phase vitreuse permet la mise en forme directe par des techniques verrières proches de celles développées pour les verres fluorés. Ainsi, une élaboration directe de rubans vitreux du composé $Bi_2 Sr_2 Ca Cu_2 O_8$ par une technique de trempe sur rouleau refroidi a déjà été démontrée.

Mais jusqu'à présent, il n'a pas été possible de réaliser un ruban ou un fil avec un matériau texturé, c'est-à-dire constitué de cristallites dont l'axe $\vec{c}$ soit commun et orthogonal à la direction de propagation du courant.

La présente invention a pour but de réaliser des fils ou des rubans dans lesquels l'oxyde supraconducteur à haute température critique soit texturé.

La présente invention a pour objet un procédé de fabrication d'un élément du genre fil ou ruban en matériau à base d'oxyde supraconducteur à haute température critique, dans lequel ledit matériau est mis en forme alors qu'il est à l'état vitreux,
caractérisé par le fait qu'il est ensuite cristallisé

- dans une première étape sous un champ magnétique, à une température $T_1$ comprise entre la température de transition vitreuse $T_g$ et la température de cristallisation $T_x$, au cours de laquelle se développent des microcristallites isolées, de taille submicronique, dont les axes $\vec{c}$ s'orientent parallèlement entre eux grâce audit champ magnétique appliqué,
- dans une seconde étape à une température $T_2$ supérieure à $T_1$ et proche de la température de cristallisation, dans laquelle les germes existants grossissent et gardent la texture induite dans ladite première étape.

Ladite seconde étape peut être poursuivie avec ou sans ledit champ magnétique.

Ledit champ magnétique est appliqué perpendiculairement aux faces principales du ruban, ou perpendiculairement à la direction du fil, et sa valeur est de l'ordre de 1 à quelques Teslas.

De nombreuses compositions supraconductrices à haute température, se prêtent à la vitrification et peuvent être mises en forme par des techniques verrières analogues à celles qui ont été développées pour les verres fluorés. Ainsi on peut choisir parmi les familles génériques des composés d'oxydes supraconducteurs à base de lanthane LaSrCuO, à base d'yttrium dont $YBa_2 Cu_3 O_7$ et $Y_2 Ba_4 Cu_8 O_{16}$, à base de bismuth dont $Bi_2 Sr_2 Ca Cu_2 O_8$ et $Bi_2 Sr_2 Ca_2 Cu_3 O_{10}$, à base de thallium dont $Tl_2 Ba_2 Ca_2 Cu_3 O_{10}$.

On peut choisir également parmi les composés substitués suivants : $EuBa_2 Cu_3 O_7$, $HoBa_2 Cu_3 O_7$, $Bi_{2-x} Pb_x Sr_2 Ca Cu_2 O_8$ et $Bi_{2-x} Pb_x Sr_2 Ca_2 Cu_3 O_{10}$ avec $0 < x \leq 0,4$.

La température $T_1$ donc est telle que :

- la viscosité du matériaux vitreux soit suffisamment faible pour permettre l'orientation des microcristallites ;
- le phénomène de nucléation-croissance s'effectue avec une cinétique suffisamment rapide.

En ce qui concerne l'orientation de l'axe $\vec{c}$ vis à vis du champ magnétique, on sait que les microcristallites alignent leur direction de plus forte aimantation parallèlement au champ magnétique (cf article D.E. Farrell et all Phys. Rev. B 36 (1987) 4025). Or le tenseur de susceptibilité magnétique X du matériau concerné est déterminé par deux valeurs principales X et $(// \vec{c})$ et $X (\perp \vec{c})$. Les monocristallites auront toutes leurs axes $\vec{c}$ parallèles entre eux et à la direction du champ magnétique si $X (// \vec{c})$ est supérieur à $X (\perp \vec{c})$ ; elles auront toutes leurs axes $\vec{c}$ parallèles entre eux et perpendiculaires à la direction du champ magnétique si $X (// \vec{c})$ est inférieur à $X (\perp \vec{c})$.

Le rapport $X (// \vec{c}) / X (\perp \vec{c})$ dépend de l'oxyde supraconducteur considéré.

Le procédé selon l'invention permet donc un formage facile d'un fil ou d'un ruban par l'utilisation de précurseurs vitreux. Il permet ensuite, par contrôle de la nucléation sous champ magnétique, de développer des cristallites primaires orientables grâce à la viscosité relativement faible du verre à haute température. Ces cristallites primaires sont la source de la forte texture du matériau totalement cristallisé dans la seconde étape, où leur croissance est développée à une température proche de la température $T_x$ du verre.

Les opérations de mise en forme et de forte texturation ont donc été rendues compatibles lors de la mise en oeuvre du procédé selon l'invention.

D'autres caractéristiques et avantages de la présente invention apparaîtront au cours de la description suivante d'un mode de réalisation donné à titre illustratif, mais nullement limitatif.

On dispose d'un ruban en matériau vitreux de composition $Bi_{1,6} Pb_{0,4} Sr_2 Ca_2 Cu_3 O_{10}$ obtenu par la technique de trempe entre deux rouleaux. Ce ruban a une largeur de 2 cm et une épaisseur de 50 $\mu$m. La température de transition vitreuse $T_g$ est 577 K et la température de cristallisation $T_x$ est 724 K. Pour ce matériau: $X$ (// $c$ ) est très supérieur à $X$ ($\perp c$ ).

On fait défiler ce ruban dans un four tubulaire ouvert où il est porté à la température $T_1 = 680$ K. On applique un champ magnétique H de l'ordre de 1 Tesla perpendiculairement à la surface principale du ruban. Au cours de cette première étape on induit des cristallites primaires par un processus de nucléation-croissance dans le verre et on oriente ces cristallites primaires par rotation dans le verre visqueux ; sous l'effet du champ H, l'axe $c$ devient parallèle à la direction de ce champ H.

Au cours de la deuxième étape le ruban défile dans un second four tubulaire où il est porté à la température $T_2 = 730$ K. On peut éventuellement maintenir à ce stade la présence du champ magnétique pour garder l'orientation initiale des cristallites, mais ce n'est pas indispensable.

A cette température, légèrement supérieure à $T_x$, la nucléation est faible et la croissance des cristallites existantes est rapide. Le matériau du ruban est donc ainsi transformé en un matériau polycristallin fortement texturé, les cristallites ayant leurs plans $CuO_2$ parallèles au plan du ruban, c'est-à-dire parallèles au courant que l'on veut y faire passer.

On peut mettre en oeuvre le procédé qui vient d'être décrit de manière analogue avec un fil de verre obtenu par fibrage d'une préforme, elle-même réalisée comme les préformes de verres fluorés.

Pour certaines applications, on enroule le ruban (ou le fil) sur son support définitif entre la première et la deuxième étape à une température $T_3$ comprise entre $T_g$ et $T_1$ de façon à tirer parti de la souplesse du matériau encore essentiellement vitreux à ce stade. Ceci n'est bien entendu possible que si le support peut subir sans dommage les conditions de la seconde étape du procédé (température et éventuellement champ magnétique).

Si les temps de traitement pendant les deux étapes du procédé aux températures $T_1$ et $T_2$ sont compatibles, le procédé peut se dérouler en continu.

Bien entendu l'invention n'est pas limitée aux modes de réalisation qui viennent d'être mentionnés. On pourra, sans sortir du cadre de l'invention, remplacer tout moyen par un moyen équivalent.

## Revendications

1. Procédé de fabrication d'un élément, du genre fil ou ruban, en un matériau à base d'oxyde supraconducteur à haute température critique, dans lequel ledit matériau est mis en forme alors qu'il est à l'état vitreux,
caractérisé par le fait qu'il est ensuite cristallisé

- dans une première étape sous un champ magnétique, à une température $T_1$ comprise entre la température de transition vitreuse $T_g$ et la température de cristallisation $T_x$, au cours de laquelle se développent des microcristallites isolées, de taille submicronique, dont les axes $c$ s'orientent parallèlement entre eux grâce audit champ magnétique appliqué,

- dans une seconde étape à une température $T_2$ supérieure à $T_1$ et proche de la température de cristallisation, dans laquelle les germes existants grossissent et gardent la texture induite dans ladite première étape.

2. Procédé de fabrication selon la revendication 1, caractérisé par le fait que la valeur dudit champ magnétique est de l'ordre de 1 Tesla.

3. Procédé de fabrication d'un ruban selon la revendication 2, caractérisé par le fait que ledit champ magnétique est appliqué perpendiculairement aux faces principales dudit ruban.

4. Procédé de fabrication d'un fil selon la revendication 2, caractérisé par le fait que ledit champ magnétique est appliqué perpendiculairement à la direction dudit fil.

5. Procédé de fabrication selon l'une des revendications précédentes, caractérisé par le fait que ledit champ magnétique est maintenu pendant ladite seconde étape.

6. Procédé de fabrication selon l'une des revendications précédentes, caractérisé par le fait que, entre ladite première et ladite seconde étapes, ledit élément est enroulé sur son support définitif à une température $T_3$ comprise entre $T_g$ et $T_1$.

7. Procédé de fabrication d'un élément selon l'une des revendications précédentes, caractérisé par le fait que ledit oxyde supraconducteur est choisi parmi les composés d'oxydes supraconducteurs à base de lanthane LaSrCuO, à base d'yttrium dont $YBa_2 Cu_3 O_7$ et $Y_2 Ba_4 Cu_8 O_{16}$, à base de bismuth dont $Bi_2 Sr_2 Ca Cu_2O_8$ et $Bi_2 Sr_2 Ca_2 Cu_3 O_{10}$, à base de thallium dont $Tl_2 Ba_2 Ca_2 Cu_3 O_{10}$.

8. Procédé de fabrication d'un élément selon la revendication 7, caractérisé par le fait que ledit oxyde supraconducteur est choisi parmi $EuBa_2 Cu_3 O_7$, $HoBa_2 Cu_3 O_7$, $Bi_{2-x} Pb_x Sr_2 Ca Cu_2 O_8$ et $Bi_{2-x} Pb_x Sr_2 Ca_2 Cu_3 O_{10}$ avec $0 < X \leq 0,4$.

## Patentansprüche

1. Verfahren zur Herstellung eines Drahts oder eines Bands aus einem Material auf der Basis eines supraleitenden Oxids mit hoher kritischer Temperatur, bei dem das Material in der Glasphase in Form gebracht wird,

dadurch gekennzeichnet, daß es anschließend kristallisiert wird, und zwar

- in einer ersten Stufe in einem Magnetfeld und bei einer Temperatur $T_1$, die zwischen der Temperatur des Übergangs in die Glasphase $T_g$ und der Kristallisierungstemperatur $T_x$ liegt, während der sich isolierte Mikrokristallite einer Größe unterhalb eines Mikrometers entwickeln, deren Achsen c sich aufgrund des angelegten Magnetfelds parallel zueinander ausrichten,
- in einer zweiten Stufe bei einer Temperatur $T_2$, die höher als $T_1$ ist und nahe der Kristallisierungstemperatur liegt, bei der die vorhandenen Keime wachsen und die in der ersten Stufe eingeführte Texturierung erhalten bleiben.

2. Herstellungsverfahren nach Anspruch 1, dadurch gekennzeichnet, daß der Wert des Magnetfelds etwa 1 Tesla beträgt.

3. Herstellungsverfahren für ein Band nach Anspruch 2, dadurch gekennzeichnet, daß das Magnetfeld senkrecht zu den Hauptflächen des Bands angelegt wird.

4. Herstellungsverfahren für einen Draht nach Anspruch 2, dadurch gekennzeichnet, daß das Magnetfeld senkrecht zur Richtung des Drahts angelegt wird.

5. Herstellungsverfahren nach einem der vorhergehenden Ansprüche, dadurch gekennzeichnet, daß das Magnetfeld während der zweiten Stufe beibehalten bleibt.

6. Herstellungsverfahren nach einem der vorhergehenden Ansprüche, dadurch gekennzeichnet, daß zwischen der ersten und der zweiten Stufe bei einer Temperatur $T_3$ zwischen $T_g$ und $T_1$ das Produkt auf seinen endgültigen Träger aufgewickelt wird.

7. Herstellungsverfahren nach einem der vorhergehenden Ansprüche, dadurch gekennzeichnet, daß das supraleitende Oxid aus den supraleitenden Oxidverbindungen auf der Basis von Lanthan, d.h. LaSrCuO, auf der Basis von Yttrium, d.h. $YBa_2Cu_3O_7$ und $Y_2Ba_4Cu_8O_{16}$, auf der Basis von Bismut, d.h. $Bi_2Sr_2CaCu_2O_8$ und $Bi_2Sr_2Ca_2Cu_3O_{10}$, oder auf der Basis von Thallium, d.h. $Tl_2Ba_2Ca_2Cu_3O_{10}$ ausgewählt wird.

8. Herstellungsverfahren nach einem der vorhergehenden Ansprüche, dadurch gekennzeichnet, daß das supraleitende Oxid ausgewählt wird aus $EuBa_2Cu_3O_7$, $HoBa_2Cu_3O_7$, $Bi_{2-x}Pb_xSr_2Ca-Cu_2O_8$ und $Bi_{2-x}Pb_xSr_2Ca_2Cu_3O_{10}$ mit $0 < x \leq 0,4$.

**Claims**

1. A method of manufacturing a component of the tape or filament kind out of a material based on a superconducting oxide having a high critical temperature, wherein said material is formed while it is in the vitreous state,

the method being characterized by the fact that the material is subsequently crystallized:
in a first step under a magnetic field and at a temperature $T_1$ lying between the vitreous transition temperature $T_g$ and the crystallization temperature $T_x$, during which step isolated microcrystallites of submicroscopic size develop and their c axes orient themselves parallel to one another because of said applied magnetic field; and
in a second step at a temperature $T_2$ greater than $T_1$ and close to the crystallization temperature, in which the existing nuclei grow while retaining the texture imparted to them during said first step.

2. A manufacturing method according to claim 1, characterized by the fact that the value of said magnetic field is of the order of 1 Tesla.

3. A manufacturing method according to claim 2, for manufacturing a tape, characterized by the fact that said magnetic field is applied perpendicularly to the main faces of said tape.

4. A manufacturing method according to claim 2, for manufacturing a filament, characterized by the fact that said magnetic field is applied perpendicularly to the long direction of said filament.

5. A manufacturing method according to any preceding claim, characterized by the fact that said magnetic field is maintained during said second step.

6. A manufacturing method according to any preceding claim, characterized by the fact that between said first and second steps, said component is wound onto its final support at a temperature $T_3$ lying between $T_g$ and $T_1$.

7. A method of manufacturing a component according to any preceding claim, the method being characterized by the fact that said superconducting oxide is selected from superconducting oxide compounds based on lanthanum LaSrcu0, based on

yttrium including $YBa_2Cu_3O_7$ and $Y_2Ba_4Cu_8O_{16}$, based on bismuth, including $Bi_2Sr_2CaCu_2O_8$ and $Bi_2Sr_2Ca_2Cu_3O_{10}$, and based on thallium including $Tl_2Ba_2Ca_2Cu_3O_{10}$.

8. A method of manufacturing a component according to claim 7, characterized by the fact that said superconducting oxide is selected from $EuBa_2Cu_3O_7$, $HoBa_2Cu_3O_7$, $Bi_{2-x}Pb_xSr_2CaCu_2O_8$ and $Bi_{2-x}Pb_xSr_2Ca_2Cu_3O_{10}$ with $0 < x \leq 0.4$.